(19) Europäisches Patentamt
European Patent Office
Office européen des brevets

(11) Publication number: **0 187 517 B1**

(12) **EUROPEAN PATENT SPECIFICATION**

(45) Date of publication of patent specification: **13.05.92**

(51) Int. Cl.5: **G03F 7/004**, G03F 7/023

(21) Application number: **85309413.4**

(22) Date of filing: **23.12.85**

(54) **High-temperature resistant, selectively developable resist.**

(30) Priority: **28.12.84 US 687306**

(43) Date of publication of application:
**16.07.86 Bulletin 86/29**

(45) Publication of the grant of the patent:
**13.05.92 Bulletin 92/20**

(84) Designated Contracting States:
**DE FR GB**

(56) References cited:
**EP-A- 0 021 019**
**EP-A- 0 140 273**
**EP-A- 0 145 355**
**EP-A- 0 164 248**
**DE-A- 2 437 422**
**DE-A- 2 462 101**
**US-A- 4 174 326**

**PHOTOGRAPHIC SCIENCE AND ENGINEERING, vol. 27, no. 3, May/June 1983, pages 114-117, Society of Photographic Scientists and Engineers, Easton, Pennsylvania, US; H. ZWEIFEL: "Polymers with pendent dimethylmaleimide groups as highly sensitive photocrosslinkable systems"**

(73) Proprietor: **EASTMAN KODAK COMPANY (a New Jersey corporation)**
**343 State Street**
**Rochester New York 14650(US)**

(72) Inventor: **Turner, Sam Richard**
**4 Woodstone Rise**
**Pittsford New York 14534(US)**
Inventor: **Houle, Conrad Gerard**
**213 Stony Point Trail**
**Webster New York 14580(US)**

(74) Representative: **Baron, Paul Alexander Clifford et al**
**Kodak Limited Patent Department Headstone Drive**
**Harrow Middlesex HA1 4TY(GB)**

EP 0 187 517 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to radiation-sensitive resists.

One of the greatest demands for improvement in integrated circuit photoresists is in the area of thermal resistance. The reason is that post-baking of resists, after development, at temperatures of 250 °C for up to 30 minutes, is commonly required in order to remove residual solvents in preparation for low vacuum ion implantation. Furthermore, the process of ion implantation itself often involves high temperature build-up. Present commercial resists, and particularly positive-working resists, tend to lack such thermal resistance. For example, positive-working resists comprising light-sensitive quinone-diazide sensitizer compounds in novolac resin binders suffer a loss of image integrity especially in the wall angles. That is, their image profiles tend to "slump" Ond they lose their line width control. This lack of resistance to heating occurs in spite of the presence of a recurring rigid ring structure (the phenylene group) as part of the polymer backbone in the novolac resin. Such rigid ring structures had been thought to contribute thermal resistance.

Resists have been described in the prior art literature wherein various synthetic polymeric binders have been blended "to increase the strength" of the images. For example. styrene-maleic anhydride copolymers or polyglutarimide polymers have been added to binders or resists, respectively, of light-sensitive layers, as described for example in U.S. Patent Nos. 4,196,003 and 4,524,121, respectively. However, such a copolymer have been found to cause very slow development times which are unacceptable for practical use. A more active solvent will wash away the desired areas more rapidly but often at the expense of the areas that are intended to remain. Proper developer selectivity provides that development will occur in 30 sec, and that the loss of thickness after 30 sec of development in the remaining resist portions (which in the positive resist are unexposed), will be no more than 10%.

In United States Patent 4,174,326, there is described a photoresist that comprises a sensitizer and an aqueous soluble binder. However, this resist also does not meet the stringent requirements mentioned above.

Thus, the problem of the present invention has been to provide an aqueous base solvent-developable binder for resists that will withstand, after development, high temperature processing at 250 °C with substantially no significant change or distortion in image profiles, with a practical development time as discussed above.

This problem is solved by providing a positive-working or negative-working resist comprising a sensitizer compound and an appropriately soluble and insensitive binder characterized in that the binder comprises a polymer having recurring units with the structural formula

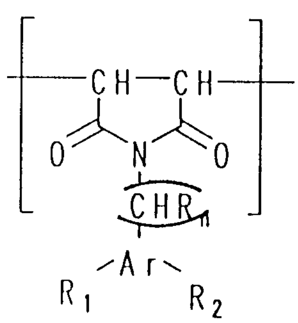

wherein Ar is substituted or unsubstituted aryl of from 6 to 10 carbon ring atoms, R is hydrogen or alkyl of 1 to 5 carbon atoms, or aryl of 6 to 10 carbon atoms, substituents R1 and R2 are individually H, -OH, -COOH, -OCO-alkyl wherein alkyl contains from 1 to 5 carbon atoms and n is an integer of from 1 to 3.

That is, it is an advantageous feature of the invention that a aqueous-developable photoresist is provided which, after sufficiently selective development, is processable up to temperatures as high as 250 °C without any significant change in the image profile.

The present invention will now be described by way of example.

The binder of this inventon is described primarily in connection with an aqueous developable, positive-working resist wherein this binder is blended with a novolac resin and exposure is to a UV source. In addition, the invention is useful when the binder herein described is the sole binder for the resist,that is, the sole polymer that is relatively insensitive to the activating radiation. It is further useful when the activating radiation is other than a UV source.

With the binder of this invention, improved aqueous developer selectivity is achievable with improved high temperature resistance. This binder has a rigid heterocyclic, nitrogen-containing ring structure, a portion of which comprises the backbone of the polymer in a recurring unit thereof. Preferably, the nitrogen atom is not in the direct backbone, but is pendant. More particularly, the most preferred examples are maleimide polymers.

As is well understood in the art the term "differential solubility" refers to, in the case of positive-working embodiments, the exposed portions of the photoresist being more soluble in the developer than the unexposed portions. In the case of negative-working embodiments, the exposed portions are less soluble than the unexposed portions.

Useful examples of Ar as an unsubstituted 6 to 10 car- bon ring are phenyl and naphthyl. Useful examples of R include hydrogen, methyl, and phenyl. Useful exam- ples of the alkyl portion of $R_1$ and $R_2$ include methyl, ethyl, propyl, butyl, and pentyl.

Particularly preferred are the above-noted maleimide polymers when such polymers are copolymerized to have as additional recurring units, those having the structural formula

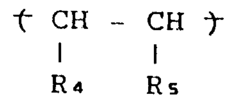

wherein

$R_4$ is 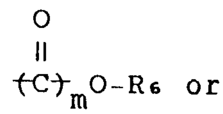 or 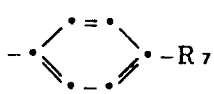;

$R_5$ is H, alkyl of from 1 to 10 carbon atoms, such as methyl, ethyl, propyl, hexyl, and the like; or aryl of 6 to 10 ring atoms, e.g., phenyl; or together $R_4$ and $R_5$ form a fused 1,8-naphthylene: $R_6$ is alkyl of 1 to 5 carbon atoms, for example, methyl, ethyl, propyl, butyl and pentyl; $R_7$ is hydrogen,
$-Si(R_6)_3$, -OH or

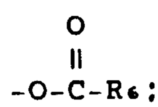;

and m is 0 or 1.

Of the aforedescribed copolymers, particularly preferred are those that provide a water-solubilizing group such as hydroxy, on at least one of the recurring units.

Thus, particularly useful binders for the photoresist include poly[N-(p-hydroxyphenyl)maleimide-co-styrene]; poly[N-(p-acetoxyphenyl)maleimide-co-ethyl acrylate): poly(N-phenylmaleimide-co-p-hydroxystyrene), and poly[N-(p-hydroxyphenyl) maleimide-co-stilbene].

If the described polymer is the sole binder of the resist, particularly preferred comonomers polymerized together with the maleimide comonomer include, individually, trimethylsilyl-substituted styrene, ethyl acrylate, stilbene, and n-butyl vinyl ether.

The molecular weight of the binder of the invention is believed to be not critical. However, the preferred maleimide copolymers are those which, when used as a blend with other binders, have a Mw between about 5,000 and 250,000 as determined by size exclusion chromatography. Mw values larger than this slow down the developability rate. If the binder of the invention is the sole binder of the resist, then preferably the Mw is between about 10,000 and about $1 \times 10_6$.

In the event the binder of the invention is a maleimide copolymer, the mole ratio of the maleimide recurring unit is not critical. Preferably, it comprises from about 10 mole % to about 95 mole %. More preferably, it is between about 40 and 55 mole %. A highly preferred embodiment is one in which the mole ratio is 50%, to produce an alternating copolymer.

It is further contemplated that other useful polymeric binders of the invention comprise those in which a recurring unit has the structural formula

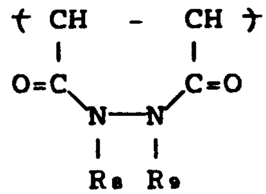

wherein $R_8$ and $R_9$ are individually hydrogen or

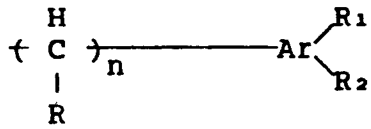

with Ar, R, $R_1$, $R_2$, and n as defined above. Such polymers are prepared by reacting the maleic anhydride with a substituted hydrazine.

As is conventional, the photoresist of the invention comprises, in addition to the binders, a compound, hereinafter called the "sensitizer", that is sensitive to the activating radiation to produce decomposition products that are more soluble in a selected developer solvent than the original sensitizer. Any such sensitizer can be used. Quinone diazide compounds are particularly useful (for example,

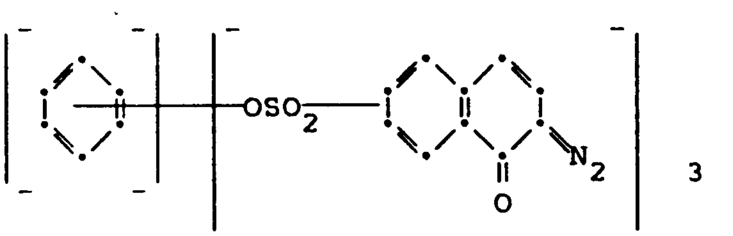

Suitable developer solvents for the decomposition products of such sensitizers include aqueous bases such as 1% by weight NaOH, 2.5% tetramethylammonium hydroxide, and methyltriethanolammonium hydroxide.

The process for preparing the polymeric binders of the invention is conventional. The following preps are illustrative of such conventional processes:

Preparation 1. Preparation of Poly[styrene-alt-N-(p-acetoxyphenyl)maleimide]*

A polymerization bottle was charged with 6.0 g (0.0258 mol) of the maleimide and 2.70 g (0.0258 mol) freshly distilled styrene. 2,2'-Azobis(2-methylpropionitrile) (AIBN) (0.06 g) was added followed by 50 ml of acetone. The bottle and contents were sparged with Argon for one minute and then the bottle was sealed. The bottle was placed into a 60 °C oil bath for a time of 28 hrs. A very viscous solution was obtained with the copolymer obtained by precipita- tion from methanol. The copolymer was dried under vacuum at 50 °C for 48 hrs. A yield of 8.3 g (78%) was obtained. GPC analyses in tetrahydrofuran (THF) gave Mw 244,600, Mn = 66,800 and Mw/Mn = 3.66. Analysis Calcd. for $C_{20}H_{17}NO_4$ (1:1 structure): C, 71.6; H, 5.1; N, 4.2. Found: C, 70.9; H, 5.1: N, 4.4.

* The term "alt" in the name is indicative that the polymer is formed by the comonomers alternating in the chain.

Preparation 2. Preparation of Poly[styrene-alt-N-(p-hydroxyphenyl)maleimide]

This process is illustrative of a standard technique to obtain the phenolic form of the copolymer.

A 500 ml round-bottomed flask was charged with 300 ml acetone and 7.0 g of the copolymer of Preparation 1. After the polymer was in solution a mixture of 30 ml of methanol and 50 ml of acetone were added along with 1.2 g of p-toluenesulfonic acid. The acetone along with the methyl acetate formed were slowly distilled off until a volume of about 50 ml remained in the flask. This viscous solution was dropped into methanol to yield a white solid. About 6.0 g (98%) polymer was obtained. This was dried for about 48 hrs at 40-50 °C in a vacuum oven. The ir spectrum showed a strong -OH bond at 3450 $cm_{-1}$ which was not present in the starting copolymer. Analyses Calcd. for $C_{18}H_{15}NO_3$: C, 73.7; H, 5.2; N, 4.8. Found: C, 71.4; H, 5.1; N, 4.7. Tg = 242 °C.

Several other copolymers were prepared in a similar fashion and are listed in Table I.

The glass transition temperatures of these copolymers were determined by differential scanning calorimetry and are listed in Table I.

**Table I - Copolymers Prepared**

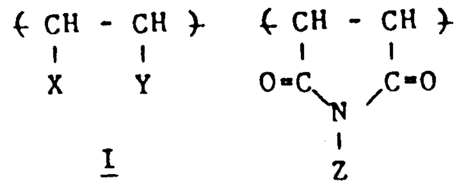

I

| Prep. No. | Structure I X | Structure I Y | Structure I Z | $\bar{Mw}$ | $\bar{Mn}$ | $\bar{Mw}/\bar{Mn}$ | Tg°C |
|---|---|---|---|---|---|---|---|
| 3 | H | 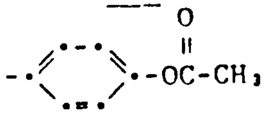 | 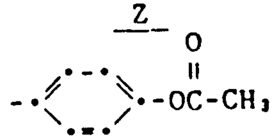 | 235,000 | 66,700 | 3.52 | 225 |
| 4 | H | 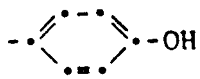 | 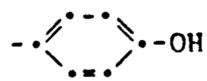 | -- | -- | -- | 258 |
| 5 | 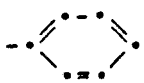 | 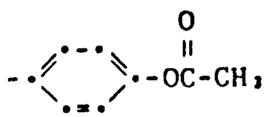 | 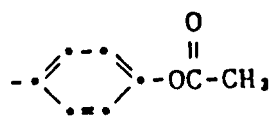 | 69,000 | 26,400 | 2.61 | -- |
| 6 | H | 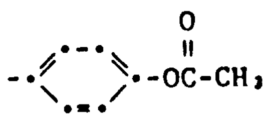 | 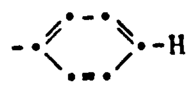 | -- | -- | -- | -- |
| 7 | X + Y = | 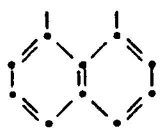 | 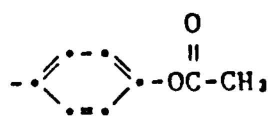 | 26,500 | 17,100 | 1.54 | 201 |

Table I (cont.)

| Prep. No. | Structure I X | Y | Z | $\overline{Mw}$ | $\overline{Mn}$ | $\overline{Mw}/\overline{Mn}$ | Tg °C |
|---|---|---|---|---|---|---|---|
| 8 | H | 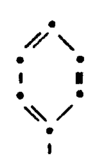 | 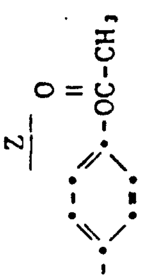 | 244,600 | 66,800 | 3.66 | 224 |
| 9 | H | 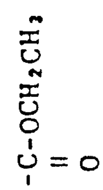 | 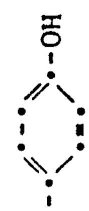 | 75,200 | 12,900 | -- | 196 |

The preparation of a copolymer of trimethyl-silyl-substituted styrene and (p-hydroxyphenyl)maleimide is similar to the above.

Preparation No. 10 - Preparation of Poly[stilbene-alt-N-(p-acetoxyphenyl)maleimide].

The following preparative example illustrates the use of dodecylthiol as a chain transfer agent to insure that low molecular weights result from the preparation of binders of this invention.

A one-liter three-necked flask was charged with 46.8 g stilbene (0.26 mol), 600 g of N-p-acetoxyphenyl maleimide (0.26 mol), 500 ml of 2-butanone, 0.4 g of 2,2'-azobis(2-methylpropionitrile) and 2.5 g of dodecylthiol as a chain transfer agent. The reaction mixture was purged with nitrogen gas for 2 minutes and then heated under a nitrogen atmosphere for a 24-hour polymerization period at 60° C. The homogeneous reaction mixture was slowly stirred over 24 hours. The product was precipitated into methanol and vacuum dried at 50° C to yield 86.0 g of a white powder. The copolymer was characterized as having Mn = 9,700, Mw = 14,400 and Mw/Mn = 1.48 (by GPC analyses.)

Preparation No. 11 - Preparation of Poly[n-butyl vinyl ether-alt-N-(p-hydroxyphenyl)maleimide]

The preparation of poly[n-butyl vinyl ether-alt-N-(p-hydroxyphenyl)maleimide] was done in a fashion similar to Preparations 1-9.

It will be appreciated that the resist is prepared by admixing the binder of the invention in an appropriate coating solvent, along with the sensitizer and optional addenda such as dyes, pigments, surfactants, plasticizers, stabilizers and the like, all of which are conventional. Also, additional polymeric binders can be added, for example, novolac resins. Particularly preferred are those resists wherein up to 90 weight % of the binder is a novolac resin. For example, any of the novolac resins described in U.S. Patent No. 4,294,911 is useful, and particularly those that are esterified cresol-formaldehyde and phenol-formaldehyde resins capped with a quinone diazide and having a weight-average molecular weight of between about 1000 and about 15,000. Such capped novolac resins generally have the structural formula

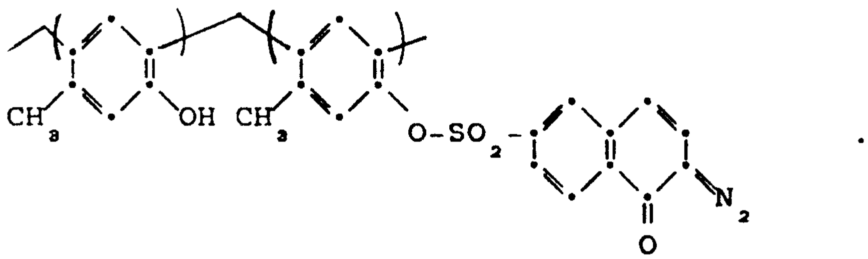

The manner of preparing the resist composition and coating it onto a substrate or support, and of exposing and developing such a coated composition, are conventional steps which require no further elaboration. Any conventional substrate or support is useful, and illustrative examples appear in the aforesaid U.S. Patent No. 4,294,911.

Examples

The following examples further illustrate the invention.

Example 1

The following were mixed to form a resist formulation:
1.8 g novolac - (wherein 3 mole % of the hydroxyl groups are capped with the quinone diazide) 0.4 g phloroglucinol-triquinone diazide**

** This is a mixture of phloroglucinol esterified with one, two, and three quinone diazide groups, i.e., a mixture of

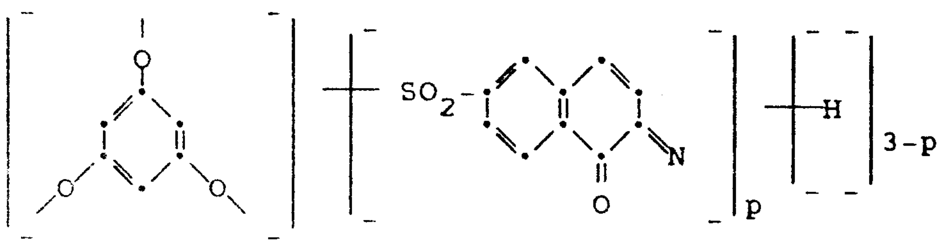

where p = 1 to 3.

0.4 g poly[p-hydroxystyrene-alt-N-(p-hydroxphenyl)-maleimide]
5.6 g cyclopentanone

The resist formulation was spin-coated at 5000 rpm on $SiO_2$ wafers, prebaked at 90 ° C for 30 minutes, exposed for 12 sec to a UV source and developed in 1% NaOH solution. The thickness loss due to development (for 10 sec) was 1.5%. For 30-sec development, such loss is expected to be less than 8%. The imaged wafers were baked at 200 ° C for 30 minutes. Scanning electron micrographs (SEMs) showed no significant change in image profiles. As used herein, "significant change" and "significant distortion" mean, that the slope of the image wall does not become less than 70 °, no change occurs in the base dimension, and no significant rounding occurs at the top of the image.

Example 2 - Poly[trans-stilbene-alt-N-(p-hydroxyphenyl)maleimide] as the Binder

The following were mixed to form a resist formulation:
2.7 g novolac-3 mole % quinone diazide
0.6 g phloroglucinol triquinone diazide
0.6 g poly[trans-stilbene-alt-N-(p-hydroxyphenyl)-maleimide],
which is Preparation No. 10 as modified by the procedure of Preparation No. 2.
8.64 g 2-ethoxyethyl acetate
0.96 g 4-butyrolactone

The resist was coated at 5000 rpm on $SiO_2$ wafers, prebaked at 95 ° C for 30 minutes, exposed for 14 sec to a 200 W UV source and developed for 15 sec using Kodak KPD Developer diluted 1:1 with water. The thickness loss due to development was 5.4%. The imaged wafers were baked at 250 ° C for 30 minutes. SEMs showed no significant change in image profile.

Example 3 - Poly[styrene-alt-N-(p-hydroxyphenyl)-maleimide] as the Binder

The following resist composition was prepared, spin-coated at 7000 rpm on a $SiO_2$ wafer, prebaked at 90 ° C for 30 minutes, exposed to a 200W UV source for 14 seconds, and developed in 2.86% tetramethylammonium hydroxide for 32 seconds. The thickness loss was 6.0%. Scanning electron micrographs showed no significant changes in image profile after postbaking to 250 ° C for 30 minutes.

Composition

2.5 g novolac-3 mole percent quinone diazide
0.54 g phloroglucinol triquinone diazide
0.54 g poly[styrene-alt-N-(p-hydroxyphenyl)maleimide]
6.75 g 2-ethoxyethyl acetate
0.75 g 4-butyrolactone

Example 4 - Use of Preparation No. 9

A resist formulation was prepared as described in Example 3 except using 0.54 g of poly-[ethyl acrylate-alt-N-(p-hydroxyphenyl)maleimide] in place of the styrene copolymer binder. The formulation was spin-coated at 8000 rpm on a $SiO_2$ wafer, prebaked at 90°C for 30 minutes, exposed to a 200 W UV source for 14 seconds, and developed in 2.86% tetramethylammonium hydroxide for 28 seconds. The thickness loss was 7.6%. Scanning electron micrographs showed no significant changes in image profile after postbaking to 250°C for 30 minutes.

Example 5 - Use of Preparation No. 11

A resist element was prepared as described in Example 4 except (1) the binder polymer used was poly-[n-butyl vinyl ether-alt-N-(p-hydroxyphenyl)maleimide], (2) the coating speed was 8500 rpm, and (3) the development time was 26 seconds. The thickness loss was 5.0% and SEMs showed no significant changes in image profile after postbaking to 250°C for 30 minutes.

Comparative Examples 1 and 2

The procedure of Example 1 and 2 was repeated, except that KMPR 820, a commercial novolac quinone diazide resist formulation without any high Tg thermally enhancing polymer added, was used as the resist. In both cases this resist showed severe rounding of images under identical 200°C baking conditions.

Example 6 - Sole Binder Example

The following were mixed to form a resist formulation:
3.0 g poly[p-(trimethylsilyl)styrene-alt-N-(p-hydroxyphenyl)maleimide]
0.3 g phloroglucinol-triquinone diazide
35 g cyclohexanone

The resist formulation was spin coated at 2000 rpm on $SiO_2$ wafers, prebaked at 90°C for 30 minutes and exposed for 10 seconds with a UV source. Wafers were developed with 5% tetramethylammonium hydroxide. High resolution images with good cleanout were noted.

Example 7 - Negative-Working Resist

A resist formulation was prepared using 3.0 g of poly[styrene-co-N-(p-hydroxyphenyl)maleimide] (Mw of 26,000) and 0.45 g of 4-t-butyl-2,5-bis-(p-azidobenzal)-cyclohexanone (the sensitizer) dissolved in 18 ml of cyclopentanone. This solution was filtered and then spin coated at 2000 rpm on a $SiO_2$ wafer. After prebaking for 30 minutes at 90°C this wafer was exposed in the contact mode to a broad band UV light source for 15 seconds. High resolution negative images were obtained by developing in 20% tetramethylammonium hydroxide solution. Scanning electron micrographs showed no image change when these images were postbaked to 200°C for 30 minutes.

**Claims**

1. A positive-working or negative-working photoresist comprising a sensitizer compound and a binder whose solubility in a selected aqueous base solvent is changed upon imagewise exposure to activating radiation and which is more insensitive to said activating radiation than said sensitizer compound,

   characterized in that said binder comprises a polymer having recurring units with the structural formula

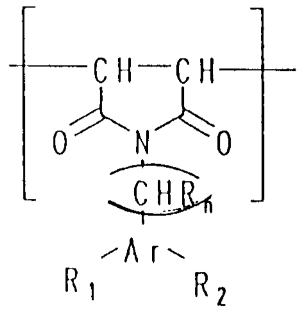

wherein Ar is substituted or unsubstituted aryl of from 6 to 10 carbon ring atoms, R is hydrogen or alkyl of 1 to 5 carbon atoms, or aryl of 6 to 10 carbon atoms, substituents R1 and R2 are individually H, -OH, -COOH, -OCO-alkyl wherein alkyl contains from 1 to 5 carbon atoms and n is an integer of from 1 to 3.

**2.** A resist as defined in claim 1 wherein said binder comprises a polymer having recurring units with the structural formula

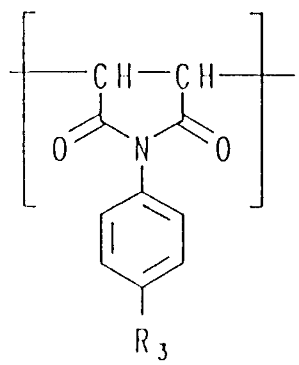

wherein R3 is H or OH.

**3.** A resist as defined in claim 1 or 2, wherein said polymer is a copolymer that further includes recurring units having the structure

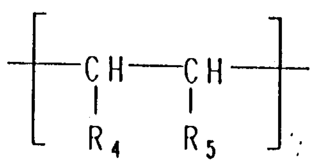

wherein R4 is

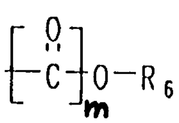

or

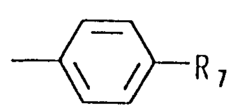

;

R5 is H, alkyl of from 1 to 10 carbon atoms, or aryl of from 6 to 10 ring atoms, or together R4 and R5 form a fused 1,8-naphthylene,
$R_6$ is alkyl of 1 to 5 carbon atoms,

$R_7$ is hydrogen,
-Si-$(R_6)_3$, -OH or -$OCOR_6$,
and m is 0 or 1.

**4.** A resist as defined in claim 1 wherein said polymer is the sole binder for said resist.

**Revendications**

**1.** Photoréserve à effet positif ou à effet négatif comprenant un composé sensibilisateur et un liant dont la solubilité dans un solvant basique aqueux choisi est modifiée par exposition photographique à un rayonnement activant et qui est plus insensible au rayonnement activant que le composé sensibilisateur,

caractérisé en ce que le liant comprend un polymère ayant des motifs de fromule :

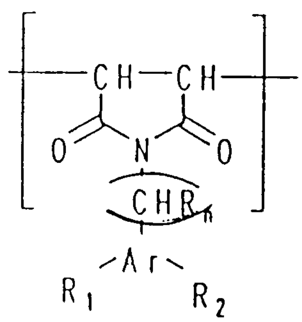

où Ar est un groupe aryle substitué ou non de 6 à 10 atomes de carbone sur le cycle, R est un hydrogène ou un alkyle de 1 à 5 atomes de carbone ; ou un groupe aryle de 6 à 10 atomes de carbone ; les substituants $R_1$ et $R_2$ sont chacun séparément H, -OH, -COOH, -OCO-alkyle où alkyle contient de 1 à 5 atomes de carbone et n est un entier de 1 à 3.

**2.** Photoréserve selon la revendication 1 où le liant comprend un polymère ayant des motifs de formule

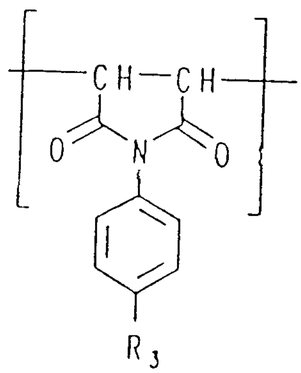

où $R_3$ est H ou OH.

**3.** Photoréserve selon la revendication 1 ou 2 où le polymère est un copolymère qui comprend de plus des motifs de formule

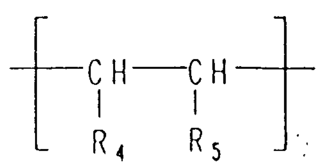

où $R_4$ est

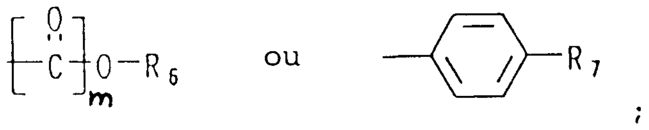

$R_5$ est H, un groupe alkyle de 1 à 10 atomes de carbone, ou aryle de 6 à 10 atomes de carbone, ou $R_4$ et $R_5$ ensemble forment un noyau condensé 1,8-naphtalène,
$R_6$ est un alkyle de 1 à 5 atomes de carbone,
$R_7$ est l'hydrogène, -Si -$(R_6)3$, -OH ou -$OCOR_6$,
et m est 0 ou 1.

4. Photoréserve selon la revendication 1 où le polymère est le seul liant de la réserve.

**Patentansprüche**

1. Positiv-arbeitendes oder negativ-arbeitendes Photoresist mit einer Sensibilisierungsverbindung und einem Bindemittel, dessen Löslichkeit in einem ausgewählten Basen-Lösungsmittel bei bildweiser Belichtung mit aktivierender Strahlung verändert wird, und das unempfindlicher gegenüber der aktivierenden Strahlung ist als die Sensibilisierungsverbindung,

dadurch gekennzeichnet, daß das Bindemittel ein Polymer mit wiederkehrenden Einheiten der allgemeinen Formel

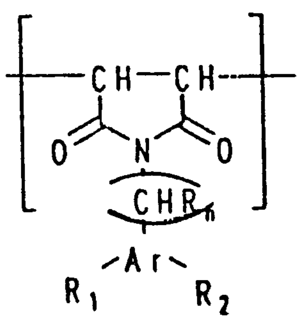

umfaßt, in der Ar substituiertes oder unsubstituiertes Aryl mit 6 bis 10 Kohlenstoffringatomen ist, R für Wasserstoff oder Alkyl mit 1 bis 5 Kohlenstoffatomen oder Aryl mit 6 bis 10 Kohlenstoffatomen steht, die Substituenten $R_1$ und $R_2$ einzeln stehen für H, -OH, -COOH, -OCO-Alkyl, worin Alkyl 1 bis 5 Kohlenstoffatome aufweist und n eine ganze Zahl von 1 bis 3 ist.

2. Resist nach Anspruch 1, in dem das Bindemittel ein Polymer mit wiederkehrenden Einheiten der Strukturformel

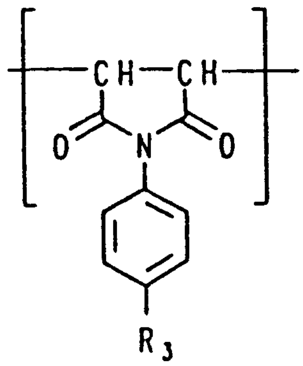

umfaßt, worin $R_3$ gleich H oder OH ist.

3. Resist nach Anspruch 1 oder 2, worin das Polymer ein Copolymer ist, das ferner wiederkehrende Einheiten der Struktur

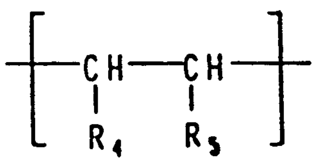

aufweist, worin $R_4$ steht für

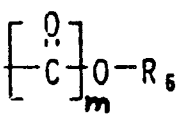

oder

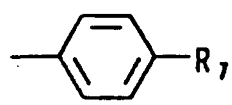

;

$R_5$ gleich H, Alkyl mit 1 bis 10 Kohlenstoffatomen oder Aryl mit 6 bis 10 Ringatomen ist oder $R_4$ und $R_5$ gemeinsam einen ankondensierten 1,8-Napthylenring bilden,

$R_6$ gleich Alkyl mit 1 bis 5 Kohlenstoffatomen ist,

$R_7$ für Wasserstoff, -Si-$(R_6)_3$, -OH oder -$OCOR_6$ steht und

m gleich 0 oder 1 ist.

4. Resist nach Anspruch 1, in dem das Polymer das einzige Bindemittel des Resists ist.